# EUROPÄISCHE PATENTSCHRIFT

(11) **EP 0 407 492 B1**
(45) Veröffentlichungstag und Bekanntmachung des Hinweises auf die Patenterteilung: **30.07.1997**
(21) Anmeldenummer: 89911554.7
(22) Anmeldetag: 07.10.1989
(51) Int. Cl.: H01B 1/12

(54) **VERFAHREN ZUR HERSTELLUNG DÜNNER SCHICHTEN AUS LEITFÄHIGEN POLYMEREN**
PROCESS FOR PRODUCING THIN LAYERS OF CONDUCTIVE POLYMERS
PROCEDE POUR FABRIQUER DES COUCHES MINCES EN POLYMERES CONDUCTEURS

(30) Priorität: 11.10.1988 DE 3834526; 03.02.1989 DE 3903200; 09.03.1989 DE 3907603
(43) Veröffentlichungstag der Anmeldung: 16.01.1991
(73) Patentinhaber: Zipperling Kessler & Co (GmbH & Co), D-22926 Ahrensburg (DE)
(72) Erfinder: WESSLING, Bernhard, D-2072 Bargteheide (DE); MERKLE, Holger, D-2070 Ahrensburg (DE)
(74) Vertreter: UEXKÜLL & STOLBERG
(86) Internationale Anmeldenummer: EP8901178
(87) Internationale Veröffentlichungsnummer: WO9004256

(56) Entgegenhaltungen:
- DE-A- 3 317 761
- FR-A- 2 616 790

## Beschreibung

Unter dem Begriff "intrinsisch leitfähige Polymere" (ICP) werden solche organischen Polymeren verstanden, die polykonjugierte Bindungssysteme (z.B. Doppelbindungen, aromatische bzw. heteroaromatische Ringe oder Dreifachbindungen) aufweisen. Beispiele für solche Polymere sind Polydiacetylen, Polyacetylen (PAc), Polypyrrol (PPy), Polyanilin (PAni), Polythiophen (PTh), Polyisothianaphthen (PITN), Polyheteroarylen-vinylen (PArV), wobei die Heteroarylen-Gruppe z.B. Thiophen oder Pyrrol sein kann, Poly-p-phenylen (PpP), Polyphenylensulfid (PPS), Polyperinaphthalin (PPN), Polyphthalocyanin (PPhc) u.a., sowie deren Derivate (die z.B. aus substituierten Monomeren aufgebaut sind), deren Copolymere und deren physikalische Mischungen. Sie können in verschiedenen Zuständen vorliegen, die durch jeweils unterschiedliche Summenformeln beschrieben werden und durch (elektro-)chemische Reaktionen wie Oxidation, Reduktion, Säure/-Base-Reaktion oder Komplexbildung zumeist im wesentlichen reversibel ineinander überführt werden können. Diese Reaktionen werden in der Literatur gelegentlich auch als "Dotierung" bzw. "Kompensation" bezeichnet oder können als "Beladung" und "Entladung" analog zu den elektrochemischen Prozessen in Batterien angesehen werden. Zumindest einer der möglichen Zustände ist elektrisch sehr gut leitfähig, z.B. mit einer spezifischen Leitfähigkeit von mehr als 10⁻² S/cm als reiner Stoff, so daß von intrinsisch leitfähigen Polymeren gesprochen wird.

Einen guten Überblick über bis heute bereits synthetisierte intrinsisch leitfähige Polymere findet man in Synthetic Metals, Nr. 17, 18 und 19 (1987).

Die Verarbeitung intrinsisch leitfähiger Polymerer (ICP) ist ein in den letzten Jahren immer wichtiger gewordenes Teilgebiet der Forschung an leitfähigen Polymeren, da sich die ursprünglich für ausreichend gehaltenen Filme, die man vor allem bei der Elektropolymerisation erhalten konnte, für die meisten ins Auge gefaßten technischen Anwendungen außerhalb des Batteriesektors als nicht geeignet herausstellten.

Die Arbeiten von B. Weßling u. a. (EP-A-168 621, EP-A-168 620, EP-A-181 587, DE-A-37 29 566) ermöglichen die Verarbeitung als reine Stoffe und als Polymerblends zu Fertigteilen in mannigfacher Form, jedoch nicht zu Produkten, in denen die ICP als fest haftende dünne Schicht auf einem Substrat oder Formteil benötigt werden. Unter dünnen Schichten versteht man solche, die eine Dicke von nicht mehr als 10µm, vorzugsweise von nicht mehr als 1µm aufweisen. Solche Schichten benötigt man z.B. als transparente Leiter oder zur transparenten antistatischen Ausrüstung, als funktionelle Schichten auf Halbleitern oder Gläsern, zur Modifizierung von Elektrodenoberflächen und Keramiken oder für andere Zwecke. Für manche Fälle sind wären ultradünne Schichten mit einer Dicke von weniger als 400 nm erforderlich.

Aus den oben zitierten Arbeiten und aus der weiteren Literatur lassen sich zur Lösung des Problems entweder keine befriedigenden oder nur für einzelne Spezialfälle geeignete Verfahren ableiten.

Gemäß D. Whitney und G. Wnek (Mol. Cryst. Liq. Cryst. 121, 313 (1985)) wird undotiertes PAc während der Polymerisation auf SiO₂-Teilchen adsorbiert (chemische Abscheidung). Nicht organofunktionell silyliertes SiO₂ eignet sich nicht, da PAc, das auf unbehandeltem SiO₂ polymerisiert wird, sofort delaminiert, wenn die Teilchen in Wasser suspendiert werden. PAc adsorbiert nur dann ausreichend bei der Polymerisation, wenn eine geeignete Glasbeschichtung vorliegt.

Nach S. Armes et al. (J. Colloid Interface Sci. 118, (2), 410 (1987)) wird eine wäßrige, mittels PVA sterisch stabilisierte kolloide PPy-Dispersion hergestellt. Die Arbeit enthält keine Hinweise darauf, daß diese Dispersion zur Herstellung dünner Schichten auf diversen Substraten geeignet sein könnte.

T. Skotheim (US-Patentanmeldung 448,115) und vorherige Anmeldungen, die darin zitiert sind (386,666; 312,888; 208,059; US-A- 4 352 868) offenbart die Herstellung einer dünnen hochleitenden Polymerschicht auf einem Halbleiter. Hierzu werden
a) dünne Schichten entweder elektrochemisch aufpolymerisiert oder
b) nach Aufbringen eines Polyelektrolyt-Films von einigen µm Stärke in der Filmmatrix chemisch oder elektrochemisch polymerisiert.

F. Garnier, G. Horowitz (Synth. Met. (im Druck, Vortrag und Poster auf der ICSM Santa Fe 1988, Abstracts S. 257, 265 u. 266) beschreiben und diskutieren die elektrochemische Abscheidung von Polythiophenen und die Abscheidung löslicher PTh-Oligomerer mittels Vakuumverdampfung (s. u.) auf Halbleitern.

Nach K. Uvdal, M. Löglund, J.-O.Nilsson, W. Salaneck Synth. Met. (im Druck, Poster auf der ICSM Santa Fe, 1988, Abstracts S. 283) wird PAni im Ultrahochvakuum bei ca 350°C verdampft und auf Substraten abgeschieden. Der Nachteil dieses Verfahrens ist im hohen apparativen Aufwand und in der Tatsache zu sehen, daß offenbar nur Oligomere abgeschieden werden können. Über die Einsetzbarkeit anderer als Quartz-Substrate ist nichts bekannt.

R. Elsenbaumer, K. Jen und R. Oboodi (Synth. Met. 15, 169 (1986); a.a.o. 18, 277 (1987)) offenbaren lösliche Polyalkylthiophene, die als dünne transparente Schichten (mit nicht bekannter Haftfestigkeit) auf Substrate aufgebracht werden können und mittlere bis gute Leitfähigkeit aufweisen. Nachteilig ist die aufwendige Herstellung der Monomeren und Polymeren.

Ähnliche Polyalkylthiophene wurden auch bereits versuchsweise zur Herstellung von Feldeffekttransistoren in der Forschung verwendet (P. Kuivalainen et al., 13th Nordic Semiconductor Meeting, Stockholm, 5.- 8. Juni 1988).

M. Feldhues, G. Kämpf, T. Mecklenburg und P. Wegener (EP-A-257 573, vgl. auch Poster auf dem Symposium des Bundesministeriums für Forschung und Technologie der Bundesrepublik Deutschland "Materialforschung 1988") beschreiben lösliche Polyalkoxythiophene (Ausgangsleitfähigkeit ca. 10⁻³ bis 10⁻⁵ S/cm), die mittels Lösungsmitteln auf PET-Folien zu transparenten dünnen Schichten verarbeitet werden können, die allerdings nur äußerst geringe Leitfähigkeiten (10⁻⁸ bis 10⁻⁹ S/cm) aufweisen. Nachteilig sind außerdem die enormen Kosten aufgrund der schweren Zugänglichkeit der Monomeren (erwartete Polymerkosten bei etwa 1000,- DM/kg).

Gemäß S. Jasne und C. Chiklis (Synth. Met. 15, 175 (1986)) wird PPy auf Latexteilchen aufpolymerisiert; spin coating transparenter antistatischer Schichten. Nachteilig sind die niedrigen Leitfähigkeiten (nur ca 10⁻⁹ S/cm) und relativ großen Teilchengrößen (0.5 bis mehrere µm dick), die Anwesenheit eines zweiten Polymers (des Latexpolymers) und die dadurch bedingte Begrenzung der Anwendbarkeit auf nur wenige Fälle.

Nach R. Bjorklund und B. Liedberg (J. Chem. Soc., Chem. Com. 1293 (1986)) werden kolloide Lösungen aus PPy-Methylcellulose-Blends unterschiedlicher PPy-Konzentration im wäßrigen Medium hergestellt; die hieraus herstellbaren Filme sind ca. 10 µm stark und nicht transparent; die Adhäsionseigenschaften werden durch die Methylcellulose-Matrix bestimmt. Dies bedingt z.B. eine schlechte Stabilität gegenüber Umgebungsfeuchte, in wäßrigen bzw. polaren Systemen etc.

B. Weßling, H. Volk und S. Blaettner EP O 329 768 berichten über Experimente zur Herstellung dispergierbarer ICP-Feststoffe, bei denen man unter Zuhilfenahme von Polyvinylpyrrolidon eine sterische Stabilisierung von Polypyrrol während der Polymerisation erreicht. Diese Dispersionen konnten nicht von Reaktionsneben- und -abfallprodukten gereinigt werden, beim Trocknen der nicht filtrierbaren Dispersionen entstand kein redispergierbarer Feststoff. Wenn die Dispersionen auf Substrate aufgebracht wurden, konnten keine transparenten bzw. gut haftenden bzw. gut leitfähigen dünnen Schichten aus reinem PPy gewonnen werden. Diese Arbeiten ergaben keine Anhaltspunkte zur Lösung der hier vorliegenden Aufgabenstellung.

Nach W. Huang und J. Park (J. Chem. Soc., Chem. Com.(ll), 856 (1987)) werden lösliche statistische Blockcopolymere aus 3-Methylthiophen und Methylmethacrylat mit einer Leitfähigkeit von nur 10⁻² bzw. 10⁻⁵ S/cm, die löslich und dadurch verarbeitbar sind, synthetisiert, es wurde eine Schicht mit nicht näher bezeichneter Dicke auf eine Pt-Elektrode aufgebracht, um die elektrochemischen Eigenschaften des Polymeren zu untersuchen. Nachteilig sind das teure, schwer zugängliche Copolymer und die geringe Leitfähigkeit.

M. Schnöller, W. Wersing und H. Naarmann (DE-A-36 30 708, vgl. auch Makromol. Chem., Macromol. Symp. 8, 83 (1987)) beschreiben ein Verfahren zur Herstellung eines Verbundwerkstoffs, mit dem eine Beschichtung eines keramischen Bauteils (Piezokeramik) durchgeführt werden kann, indem die Oberfläche des keramischen Werkstoffs mit dem Monomer beschichtet wird, das dann polymerisiert wird. Im Prinzip handelt es sich um ein chemisches Abscheidungs- bzw. Beschichtungsverfahren. (Das Verfahren wird auch in umgekehrter Weise beschrieben: eine Schicht der Lösung des Oxidations-und Dotierungsmittels wird vorgelegt und diese Schicht mit dem Monomer beaufschlagt). Die elektrochemische Abscheidung birgt als Nachteil den relativ hohen apparativen Aufwand im technischen Maßstab in sich, die beschriebene chemische Abscheidung das Problem, daß man die gebildete Schicht nicht ausreichend von Reaktionsneben- und Abfallprodukten reinigen kann. Neben Pyrrol werden auch Thiophen oder Azulen oder deren Derivate verwendet.

Gemäß die FR1616790 wird eine ICP-Dispersion auf einem Substrat aufgetragen und anschließend das ICP durch Abdampfen des Lösungsmittels abgeschieden. Die verwendete ICP-Dispersion enthält polymere Anionen (Latex mit anionischen Gruppen).

A. Tsumura, M. Tsunoda, Y. Hizuka und T. Ando (JP-A-61/202469) beschreiben eine Methode zur Herstellung eines Feldeffekttransistors, wobei der zu beschichtende Halbleiter in eine wäßrige Lösung eines Oxidationsmittels (z.B. FeCl₃) getaucht wird, wonach eine wäßrige Lösung von N-Methylpyrrol zugegeben wird. Nach 2 Stunden hat sich eine dünne Schicht abgeschieden. Der beschichtete Halbleiter wird im Vakuum getrocknet. Der Nachteil dieser chemischen Beschichtungstechnik ist in der Unreinheit der Schicht (höherer Carbonylgruppenanteil, Eisengehalt, vgl. Chemistry Letters, Chem. Soc. Jap., 863 (1986)) zu sehen, weshalb die Erfinder in späteren Arbeiten offenbar auf elektrochemische Beschichtungstechniken und auf andere Polymere übergegangen sind (JP-A-63/14471, 63/14472, 62/31174 und H. Koezuka et al., Appl. Phys. Lett. 49, 1210 (1986)). Ein weiterer Nachteil des beschriebenen Verfahrens ist es, daß "intrinsisch leitfähige Polymere (ICP)" im Sinne der oben gegebenen Definition nicht verwendbar sind und die abgeschiedenen Schichten daher nur eine Leitfähigkeit von ca 10⁻⁵ S/cm aufweisen.

Zusammenfassend läßt sich feststellen, daß noch keine technisch befriedigende Lösung gefunden wurde, dünne Schichten aus leitfähigen Polymeren auf unterschiedliche Substrate aufzubringen. Die wesentlichen Nachteile der bisher beschriebenen Techniken sind:
- Unwirtschaftlichkeit wegen enormer Kosten der Monomeren bzw. Polymeren (vor allem bei löslichen Polymeren und Copolymeren)
- Unwirtschaftlichkeit wegen zu hohen apparativen Aufwands (elektrochemische Abscheidung oder Vakuum-Sputter-Technik)
- Unwirtschaftlichkeit wegen ungenügender Anwendungsbreite des Verfahrens
- Schichtdicke zu groß oder nicht genügend kontrollierbar
- mangelnde chemische Reinheit der Schicht (zu hoher Anteil an Neben- und Reaktionsabfallprodukten) vor allem bei chemischen, aber auch bei elektrochemischen Beschichtungstechniken
- mangelnde Haftung.

Es ist daher die Aufgabe der Erfindung, ein möglichst breit anwendbares Verfahren zur Herstellung dünner und ultradünner Schichten auf möglichst beliebigen Substraten zu schaffen. Eine große Vereinfachung würde allein dadurch ermöglicht, wenn für durchaus verschiedenartige Verfahren zur Herstellung der Schicht ein einziger Rohstoff verwendet werden könnte. Die Aufgabenstellung kann also präzisiert werden, ein Verfahren zur Herstellung dünner oder ultradünner Schichten zu schaffen, das auf der Verwendung eines bestimmten ICP-Rohstoff-Typs basiert.

Überraschend wurde gefunden, daß gut haftende dünne bzw. ultradünne Schichten mit einer spezifischen Leitfähigkeit > 10⁻² S/cm in kontrollierter Weise (insbesondere durch Variation der Bedingungen wie Temperatur oder Dauer des Beschichtungsverfahrens) hergestellt werden können, wenn die leitfähige Komponente durch Abscheidung aus einer metastabilen Dispersion von Polyanilin (PAni) aufgebaut wird.

Insbesondere ist es überraschend, daß das Polymer stromlos auf dem Substrat abgeschieden werden kann, wobei eine Schicht entsteht, deren Dicke und Dichte nicht unmittelbar von der Konzentration der Dispersion abhängig ist, d.h. es bildet sich ein Konzentrationsgradient des leitfähigen Polymeren zwischen der Dispersion und dem kontaktierten Substrat aus, so daß eine hohe Konzentration an der Grenzfläche entsteht.

Als "stabil" wird eine ICP-Dispersion bezeichnet, die in praktikablen Beobachtungszeiträumen keine Entmischungserscheinungen, auch nicht bei Temperaturänderungen oder in einer Zentrifuge zeigt. "Metastabil" sind Dispersionen von ICP, die nur unter bestimmten Umständen stabil sind, also nicht ausflocken, sich nicht entmischen, entfärben oder absetzen. Metastabile Dispersionen sind unter normalen Umständen, z.B. bei Raumtemperatur stabil, werden aber unter anderen Umständen, z.B. bei Temperaturerhöhung oder - erniedrigung oder - wie meist im Falle des erfindungsgemäßen Verfahrens - bereits beim Kontakt mit dem Substrat instabil.

Die Metastabilität der erfindungsgemäßen Dispersionen äußert sich in den meisten Fällen aber nicht durch Ausflokken oder dergleichen, sondern durch die stromlose Ascheidung des ICP aus der Dispersion auf dem Substrat.

Alc ICP-Rohstoff verwendet man unlösliches intrinsisch leitfähiges Polyanilin in Form eines dispergierbaren Feststoffes, wie er in der DE-A-37 29 566 beschrieben ist. Unlösliches Polyanilin, das nicht nach der angegebenen Vorschrift hergestellt wurde, ist zwar auch einsetzbar, die Ausbeute beim Dispergieren ist aber wesentlich schlechter.

Als Dispersionen kommen solche unter Verwendung gewöhnlicher niedermolekularer organischer Lösungsmittel oder wäßriger Medien, insbesondere Wasser in Betracht.

Die Dispersionen sind metastabil, wobei mindestens ein Teil des ICP-Feststoffes während der Beaufschlagung des Substrates in dispergierter Form vorliegt. Deshalb kann man auch unter Umständen Substrate in die laufende Polymerisation tauchen und dabei beschichten. Dabei ist es wesentlich, daß man nicht in der in der Literatur beschriebenen Weise (vgl. Whitney und Wnek, Schnöller et al. und Tsumura et al., s.o.) eine chemische Abscheidungstechnik verwendet, sondern auch während der Polymerisation eine Abscheidung aus der (wäßrigen) Dispersion ausführt. Die Abscheidung kann dann auch während der Polymerisation weiterer Mengen des dispergierbaren Polyanilins erfolgen. Dieses Verfahren wird aber aus verfahrenstechnischen Gründen weniger bevorzugt.

Bevorzugt ist es, Polyanilin in Form eines dispergierbaren Feststoffes in Wasser, organischen Lösungsmiteln (wie Alkoholen, Ethern, DMF, DMSO, u.a.) zu dispergieren (dazu kann man auch geringe Mengen an Dispersionshilfsmitteln verwenden) und die Dispersion mit dem zu beschichtenden Substrat in intensiven Kontakt zu bringen. Es können auch Dispersionen der kompensierten Formen des Polyanilins verwendet werden.

Zur Herstellung der Dispersionen eignen sich im Prinzip alle Lösungsmittel mit einem Löslichkeitsparameter von ≥ 8,6 [cal/cm³]^{1/2}, darunter vor allem Alkohole, Ester, Ether (wie z.B. THF oder Dioxan), nitrogruppenhaltige Lösungsmittel (wie Nitromethan, -propan, -benzol), DMF, DMSO, Acetonitril, H₂O, halogenierte Lösungsmittel, Malodinitril, Butyrolacton, u.a. Es sind auch Gemische dieser Lösungsmittel verwendbar.

Metastabile Dispersionen erhält man, wenn man die leitende ("dotierte") Form des Polyanilins in einem der angegebenen Lösungsmittel dispergiert. Die neutralen Formen hingegen bilden meist stabile Dispersionen. Nicht alle metastabilen Dispersionen eignen sich gleichermaßen gut zu Beschichtungszwecken. Lösungsmittel mit einem nur knapp über 8,6 liegenden Löslichkeitsparameter, besonders solche mit geringem Polaritätsanteil, vermögen nur wenig ICP zu dispergieren (d.h. die Konzentration an dispergiertem ICP ist zu gering), und die Metastabilität ist besonders stark ausgeprägt (z.B. im Kontakt mit einem Substrat gleichzeitig Ausflockungsvorgänge).

Bevorzugt sind daher solche metastabilen Dispersionen, bei denen die Metastabilität möglichst ausschließlich zur Abscheidung der ICP-Schicht auf dem Substrat führt. Solche erfindungsgemäßen metastabilen Dispersionen kann man bevorzugterweise herstellen, indem man Gemische von Lösungsmitteln, welche eine stabile Dispersion ergeben (z.B. DMF, DMSO), mit solchen, in denen besonders metastabile Dispersionen vorliegen (z.B. Alkohole, Ether) zur Dispersion verwendet. Besonders bevorzugte Ausführungsformen beschreiben die Beispiele 1 und 2.

Eine mögliche Vorgehensweise zur Herstellung der geeigneten Dispersionen besteht darin, daß man ein fertig polymerisiertes, gereinigtes und ggf. getrocknetes, konjugiertes organisches Polymer in neutraler (nicht komplexierter) Form in möglichst hoher Konzentation in eine Vordispersion überführt, indem man das Polymer in DMSO, DMF, THF oder einem anderen Lösungsmittel mit vergleichbarem oder höherem Löslichkeitsparameter dispergiert. Anschließend wird mit dem gleichen Lösungsmittel oder -gemisch oder mit einem weiteren Lösungsmittel(gemisch) mit einem Löslichkeitsparameter von > 8,6 [cal/cm³]^{1/2} verdünnt, worauf das neutrale konjugierte Polymer mit einer Säure in die leitfähige komplexierte Form überführt wird.

Es ist vorteilhaft, aber nicht zwingend erforderlich, den Dispersionsvorgang durch Zuführung von Energie, z.B. durch Ultraschall, mit einem Ultraturrax oder ähnlichen zu unterstützen. Dispersionshilfsmittel sind nur eingeschränkt einsetzbar, insofern sie nicht die Schichtbildung behindern. Bevorzugt sind solche Dispersionshilfsmittel, die zugleich "Dotierungs"- (d.h. Komplexierungs-, Oxidations-bzw. Protonierungs-) Funktionen ausüben können, wie z.B. Dodecylbenzolsulfonsäure (DBSH).

Die Dispersionen können außerdem auch filmbildende Polymere enthalten, wenn man nach der Ausbildung der dünnen PAni-Schicht auf dem Substrat auf dieser noch eine Schutzschicht benötigt. Die polymere Schutzschicht kann natürlich auch als getrennter Schritt nach der PAni-Schichtbildung und der Wärmebehandlung aufgebracht werden, in manchen Fällen erweist es sich aber als praktikabler, die PAni-Schichtbildung durch stromlose Abscheidung aus einer metastabilen Dispersion, die bereits filmbildende Polymere enthält, auszuführen, wobei zuerst die PAni-Schicht abgeschieden wird und dann beim Entfernen und Trocknen des Dispersionsmittels der polymere Schutzfilm gebildet wird. Als Polymere kommen alle filmbildenden Polymere, die in den Dispersionsmitteln löslich oder dispergierbar sind, infrage, bevorzugt sind Vinylacetat/Vinylchlorid-Copolymere, Polyurethane u.a.

Die Konzentration des dispergierten leitfähigen Polyanilins in den Lösungsmitteln liegt im Bereich von 0,1 bis 5 .-%. Auf der einen Seite sind es wirtschaftliche Gründe, die eine Maximierung der Konzentration wünschenswert erscheinen lassen, aber Gelbildung, Flokkulation, Fließ- und Schichtbildungsprobleme verhindern häufig eine Anwendung höherer Konzentrationen. Auf der anderen Seite empfiehlt es sich in manchen Fällen (wenn man extrem gelichmäßige Schichten erzeugen will), niedrige Konzentrationen einzusetzen, bei denen dann allerdings besonders lange Kontaktzeiten erforderlich sind.

Während die obigen Vorschriften zur Herstellung von zur Beschichtung geeigneten Dispersionen im allgemeinen ausreichen, wendet man vorteilhafterweise spezielle Varianten an, wenn man extrem hohe oder besonders niedrige oder exakt reproduzierbare Konzentrationen einstellen will. Für den ersten Fall dispergiert man zuerst neutrales, kompensiertes PAni (oder leitet NH₃ in eine überkonzentrierte Suspension/Dispersion von komplexiertem PAni) in einem der obengenannten Lösungsmittel, vor allem THF, DMSO, DMF und H₂O, filtriert oder zentrifugiert etwaige undispergierte Anteile ab und dotiert anschließend exakt. Die Konzentration kann durch Ermittlung des Trocknungsrückstandes festgestellt werden. Diese Herstellungsvariante ist auch zur Einstellung exakt bemessener Konzentrationen geeignet. Will man besonders geringe Konzentrationen einstellen, so verwendet man bevorzugterweise die Dispersion einer beginnenden Polymerisation. Hierzu wählt man die Polymerisationsbedingungen, wie in EP 0 329 768 angegeben, stoppt aber die Zugabe des Oxidationsmittels nach einiger Zeit. Die entstehende Dispersion ist beschichtungsaktiv und zur Herstellung besonders regelmäßiger Beschichtungen geeignet. Das Polyanilin enhält keine Gegenionen mit einem Molekulargewicht von mehr als 1000.

PAni ist durch eine reversible Oxidation oder Reduktion und/ oder durch reversible Protonierung bzw. durch andere Derivatisierungsreaktionen (die man zum Teil als Komplexierungs- bzw. Kompensationsreaktion bezeichnen kann) in konjugierte, positiv oder negativ geladene Polymerketten überführbar (deren Ladung durch Gegenionen kompensiert wird), wodurch das Polymer in Zuständen unterschiedlicher Leitfähigkeit (die chemisch gewöhnlich unterschiedlich zusammengesetzt sind) existieren kann. Die Leitfähigkeit der Polyanilinschichten ist größer als 10⁻² S/cm.

Das Polyanilin kann je nach Anwendungszweck in neutraler, reduzierter oder oxidierter Form bzw. protonierter/deprotonierter Form gewonnen und in den weiteren Verfahren verarbeitet und angewendet werden.

Kolloide Dispersionen, die z.B. sterisch mit PVA oder PVP stabilisiert sind, eignen sich weniger gut. Diese haften z.T. schlecht auf den Substraten oder - wenn man die Substrate mit den Dispersionen beschichtet und anschließend trocknet - ergeben sie unregelmäßige Schichtdicken, mangelhafte Leitfähigkeiten und eine mit dem sterischen Stabilisator "verunreinigte" Schicht, was sie für viele Anwendungen nicht geeignet macht.

Für den Erfolg des Verfahrens ist es wichtig, die Verweilzeit und die Temperatur während der Beschichtung zu kontrollieren. Bei Verwendung von Dispersionen in Lösungsmitteln sollte man eine Verweilzeit von 10 bis 60 sec. nicht unterschreiten. Je länger die Verweilzeit gewählt wird, umso dicker und dichter werden die aufgebauten Schichten und umso höher die erzielbaren Leitfähigkeitswerte.

Zum kontrollierten Aufbau kann man auch mehrfach beschichten und jeweils schonend trocknen.

Während der Beaufschlagung des Substrates mit der PAni-Dispersion scheidet sich die Schicht des leitfähigen Polymeren ab. Ist die Abscheidung vollendet, entfernt man die Dispersion. Dispersionen in Wasser oder Lösungsmitteln läßt man abfließen und entfernt schonend das (die) Lösungsmittel.

Anschließend erfolgt die Trocknung bzw. der Wärmebehandlungsschritt. Dieser Verfahrensschritt stellt einen für die Haftung der abgeschiedenen Schicht auf den Substraten wichtigen Schritt dar. In manchen Fällen kann die zur Trocknung erforderliche Erwärmung bereits die erfindungswesentliche Wärmebehandlung darstellen. In kritischen Fällen empfiehlt es sich aber, die Trocknung äußerst schonend vorzunehmen, um das Gefüge der Schicht und den Verbund mit dem Substrat nicht zu (zer-)stören. In diesen Fällen stellt der Wärmebehandlungsschritt einen getrennten Schritt dar, der bei oberhalb 60°C, bevorzugt oberhalb 80°C, in besonders anspruchsvollen Fällen oberhalb 120°C, immer aber unterhalb der Zersetzungstemperatur ausgeführt wird. Die Erwärmung des Substrats mit der aufgebrachten Schicht erfolgt beispielsweise durch direkten Kontakt mit einer Wärmequelle oder durch Infrarotstrahlung oder durch Mikrowellen. Die Dauer bestimmt sich nach den Haftungs- bzw. Kratzfestigkeitserfordernissen und liegt bei mehr als 1 in. Je länger die Wärmebehandlung dauert und je höher die angewandten Temperaturen sind, umso mehr empfiehlt es sich, diesen Schritt unter Inertatmosphäre (N₂, Edelgase) oder unter reduziertem Druck (Vakuum) auszuführen.

Der Erfolg dieses Wärmebehandlungsschrittes zeigt sich darin, daß die aufgebrachten Schichten anschließend auch mit den zur Dispersion verwendeten Lösungsmitteln oder Wasser gar nicht oder nur noch sehr schwer vom Substrat abzulösen sind. Gegen Abrieb sind sie (je nach Substrat) z.T. sehr fest (z.B. auf PC und auf Metallen), z.T. ausreichend fest (z.B. auf PET und Glas) oder weniger stabil (z.B. auf PE).

Gemäß einer alternativen Ausführungsform ist es möglich, die Beaufschlagung der Substrate bei Temperaturen oberhalb 25°C durchzuführen. Unter Umständen ist es auf diese Weise möglich, die Wärmebehandlung schon während der Abscheidung der Schicht vorzunehmen.

Mit Hilfe des erfindungsgemäßen Verfahrens lassen sich extrem dünne Schichten erzeugen, es können jedoch auch Beschichtungen bis zu einer Schichtdicke von etwa 10 µm aufgebaut werden. Es ist deshalb auch möglich, das zumindest beim ersten Abscheidungsschritt verwendete Substrat von der aus dem intrinsisch leitfähigen Polymer aufgebauten Schicht abzutrennen, um Formteile zu erhalten, welche ausschließlich aus dem intrinsisch leitfähigen Polymer bestehen.

Die beschriebenen Verfahrensschritte können sowohl als getrennte Schritte in einem diskontinuierlichen Verfahren (Folienstücke, Glasplatten, Faserrollen), als auch im kontinuierlichen Verfahren ausgeführt werden. Z.B. wählt man in einer Dispersion eine Konzentration zwischen 0,1 und 5 % PAni (komplexiert) in einem offenen Bad. Durch dieses Bad zieht man mit einer Geschwindigkeit von 0,1 bis über 1 m/Min eine Endlos-Rolle einer PC- oder PET-Folie. Oberhalb des Bades sind 1 bis 3 IR-Lampen in einem Abstand von ca. 15 cm angeordnet, so daß einerseits eine vollständige Trocknung der Folie erfolgt, andererseits die Temperatur nicht zu hoch wird (Gefahr des Verziehens oder Schmelzens). Falls eine Erhöhung der Leitfähigkeit gewünscht wird, kann man in einem wäßrigen Säurebad (z.B. 1M, HCl, organische Sulfonsäuren etc.) nachdotieren ( > 30 Min.).

Als Substrate, auf die die Schichten aufgetragen werden, kommen überraschenderweise nahezu alle Stoffe, Werkstoffe, Werkstücke, Halbzeuge oder Endprodukte infrage. Mit dem beschriebenen Verfahren konnten folgende Stoffe erfolgreich beschichtet werden:
- Metalle (Gold, Platin, Eisen, Stahl, Kupfer, Aluminium)
- Halbleiter (Silicium, Galliumarsenid)
- Kunststoffe (PE, PTFE, PA, PC, PET, Epoxyharze, auch leitfähig ausgerüstet, in Form von Pulver, Granulat, Platten, Formteilen, Folien, Fasern, Textilien etc.); hier ist die Haftfestigkeit auf polaren Stoffen besser als auf unpolaren, so daß man unpolare z.B. durch Sulfonierung, Corona-Entladung oder dergl. vorbehandeln sollte
- Naturprodukte und daraus gefertige Produkte (Holz, Baumwolle, Schafwolle)
- Gläser (SiO₂, In/Sn-Glas (ITO), SnO₂)
- Pigmente (TiO₂, Ruß, anorganische, z.B. Cadmiumpigmente, organische, z.B. Azo-Pigmente)
- synthetische und natürliche Füllstoffe, die in der Gummi- und Kunststoffverarbeitung eingesetzt werden (Kreide, Talkum, Kieselsäuren, Glasfasern, Kohlefasern, anorganische Whisker u.a.),
so daß von einer uneingeschränkten Anwendbarkeit des Verfahrens bei den verschiedensten Substraten gesprochen werden kann.

Die fertigen Beschichtungen zeigen sowohl bekannte als auch überraschende Eigenschaften, die für verschiedene Anwendungen interessant sind:
- die Schichten sind transparent
- die Leitfähigkeit ist einstellbar zwischen ca. 1·10⁻² und bis ca. 10 S/cm, in besonders sorgfältig ausgeführten Beschichtungen erreicht man noch um mehrere 10er-Potenzen höhere Leitfähigkeiten
- gute bis sehr gute Haftfestigkeit
- glatte, regelmäßige Schichtdicke und Oberfläche
- Erhaltung der chemischen (Redox-)eigenschaften (d.h.: die Schichten können chemisch oder elektrochemisch kompensiert und komplexiert, oxidiert und reduziert werden; dabei ändern sich Farbe, Leitfähigkeit und chemisches Potential)
- hohe Thermostabilität
- im Kontakt mit z.B. Eisen (Stahl), Aluminium oder anderen Metallen, die unedler als Silber sind, werden offenbar dünne, dichte Metall-Oxidschichten aufgebaut
- Schottky-Barrieren.

Als Anwendungsgebiete sind deshalb, ohne daß dies schon vollständig überblickbar wäre, folgende möglich:
- antistatische und leitfähige Modifizierung von Kunststoff(-Halbzeug- oder -Produkt-)Oberflächen, z.B. zur Verpackung von elektronischen Bauteilen
- antistatische und leitfähige Modifizierung von Oberflächen, z.B. zur Modifizierung von Elektroden (z.B. zur Katalyse oder zur Erniedrigung von Überspannung)
- Vorbehandlung von Kunststoff-Formteilen zur anschließenden Galvanisierung
- Korrosionsschutz
- Kondensatoren
- elektronische Bauelemente
- Solarzellen
- transparente leitfähige Glasbeschichtungen zur spannungsgesteuerten Änderung der Absorptionseigenschaft, die der Sonneneinstrahlung angepaßt werden kann
- funktionelle (z.B. Piezo)keramiken
- transparente Lautsprecher
- EMI-Abschirmung mit transparenten Bauteilen (z.B. Folien, Schichten auf Gläsern, Bildschirmen usw.)
- dünne Leiterbahnen, mit denen auch hohe Stromdichten transportiert werden können.

Zur Erläuterung der Erfindung sollen die folgenden Beispiele dienen, auf welche die Erfindung jedoch nicht beschränkt ist.

### Beispiel 1

In den Reaktor, in dem die intrinsisch leitfähigen Polymeren gemäß EP 0 329 768 polymerisiert werden, werden zu Beginn der Reaktion für 10 Minuten die zu beschichtenden Substrate eingehängt. Z.B. wird dies während einer Polymerisation von Polyanilin mit Benzolsulfonsäure als Gegenion ausgeführt mit einer
- PET-Folie
- PE-Platte
- Platin-Elektrode.
- Glasplatte
Nach der Beschichtung werden die beschichteten Substrate intensiv mit 1 M wäßriger Benzolsulfonsäurelösung, anschließend mit Toluol gewaschen und an der Luft getrocknet. Die Beschichtung ist nicht kratzfest.

Die Substrate werden anschließend in einer evakuierten glove-box auf einer temperierten Heizplatte 30 Min. bei 110°C wärmebehandelt. Danach haften die Schichten äußerst fest. Die Schichtdicke beträgt etwa 500 nm, die Schicht ist intensiv grün gefärbt, aber klar und transparent. Die spezifische Leitfähigkeit ist (gemessen an der PET-Folie und an der Glasplatte) ca. 5 - 10 S/cm. Dünnere und optisch weniger dichte Schichten erhält man, wenn man die Beaufschlagungszeit kürzer wählt. Der Oberflächenwiderstand beträgt dann etwa 10⁵ Ω (spez. Leitfähigkeit weiterhin 5 - 10 S/cm).

### Beispiel 2

Die zu beschichtenden Substrate
- PET-Folie
- Polyesterfasern
- Pt-Elektroden
- Goldelektroden
- Glasplatte
werden in eine gemäß EP 0 329 768 hergestellte Dispersion von Polyanilin in DMSO getaucht. Nach einigen Minuten hat sich eine transparente leicht grüne Schicht abgeschieden. Die Dicke der Schicht ist deutlich geringer als 400 nm. Die Wärmebehandlung erfolgt wie in Beispiel 1, im Falle der Fasern unter Stickstoffatmosphäre (in der glove box) und unter IR-Bestrahlung. Leitfähigkeit ca. 10⁻¹ S/cm.

### Beispiel 3

In einer zu den Beispielen 1 und 2 analogen Weise werden beschichtet:
- piezoelektrische Keramik
- Silicium-Halbleiter (Wafer)
Es ergeben sich vergleichbare Resultate in Schichtdicke und Leitfähigkeit. Die Keramik kann als Piezogeber eingesetzt werden.

Der beschichtete Halbleiter zeigt Schottky-Charakteristik.

### Beispiel 5

In einer Variante der in Bespiel 1 beschriebenen Dispersionsbeschichtung, bei der die Vorschriften der EP 0 329 768 angewendet werden, wird wie folgt vorgegangen: 57,6 g p-Toluolsulfonsäure (technische Qualität) werden in einem Becherglas in 3 l Wasser gelöst. Hinzu gibt man 20 ml Anilin. In einem weiteren Becherglas werden 32 g Peroxidisulfat in 165 ml E₂O gelöst und in einen Tropftrichter gegeben. Die Synthese wird gemäß den Vorschriften der o.a. PCT-Anmeldung unter Kühlung, gelindem Rühren und bei Einhaltung eines Potentials von 670 mV ausgeführt. Die zu beschichtenden Substrate werden entweder zu Beginn der Reaktion oder innerhalb der ersten Stunde der Durchführung der Reaktion für etwa 10 Minuten mit der fertigen Dispersion des frisch entstandenen Polyanilin/p-Toluolsulfonsäure-Salzes kontaktiert. Es zeigt sich, daß es für die Beschichtung nicht wesentlich ist, daß während der Kontaktierzeit die Peroxidlösung zugetropft wird. Man kann auch die Zugabe von Peroxid unterbrechen, unbeschichtete Substrate in das Becherglas hängen und nach einer Kontaktzeit mit der Dispersion von einigen Minuten (ca. 10 -

20 Minuten) das fertig beschichtete Substrat entnehmen und dann die Reaktion, wie oben angegeben, fortsetzen. Entscheidend für den Erfolg der Dispersionsbeschichtung ist das Vorliegen einer äußerst feinteiligen Dispersion des fertig polymerisierten PAni-pTs-Polymeren. Die fertig beschichteten Substrate werden wie oben getrocknet und wärmebehandelt.

Die nach dieser Variante erhaltenen Schichten auf PET-Folien (andere Substrate sind ebenso einsetzbar) sind je nach Kontaktzeit mit der Dispersion zwischen 50 und 80 bis 400 und 500 nm dick. Die nach dieser Variante erhaltenen Schichten zeigen nach Reinigung und Trocknung eine spezifische Leitfähigkeit von 10 bis 200 S/cm.

### Beispiel 6

### Herstellung einer Dispersion von neutralem Polyanilin in DMSO

Ein nach dem Verfahren der PCT-Anmeldung hergestelltes Polyanilin-Pulver wird 3 - 6mal mit wäßriger 3 M Ammoniaklösung gewaschen. Dabei wird PAni kompensiert. Das so vorbereitete PAni wird abgefiltert und schonend getrocknet (Raumtemperatur, Rotationsverdampfer). Der Wassergehalt nach der Trocknung sollte kleiner als 50 % sein. Das getrocknete PAni-Pulver wird durch Zuführen hoher Dispersionsenergie (z.B. Ultraschall oder Ultra-Turrax) in DMSO dispergiert. Dabei muß das Pulver vorsichtig in kleinen Schritten zugegeben werden, um eine Verklumpung zu vermeiden.

Sofort nach der ersten Zugabe des PAni-Pulvers färbt sich die Dispersion tiefblau.

Je nach Zugabemenge und Teilchengröße des verwendeten PAni wird die Dispersion bei einem Gehalt von 0,5 bis 5 % zunächst dickflüssig, oberhalb dieser Konzentration bildet sich ein sturzfähiges Gel.

Eine so hergestellte Dispersion wird durch ein grobmaschiges Sieb (z.B. ein Metallsieb) von den gel- und gummiartigen Anteilen und danach durch einen feineren Filter von kleineren Agglomeraten und Verunreinigungen befreit.

Statt DMSO kann man auch DMF, THF oder andere geeignete Lösungsmittel verwenden.

### Beispiel 7

### Herstellung einer zur Beschichtung geeigneten Dispersion.

Eine Dispersion aus Beispiel 6, vorzugsweise nahe der Gelgrenze, wird verdünnt im Verhältnis 1 : 1 z.B. mit Isopropylalkohol (andere Lösungsmittel eignen sich auch, aber offenbar weniger gut), der die Dotierungssäure (z.B. DBSH) in einer Konzentration des ca. 0,75fachen der PAni-Konzentration in DMSO-Dispersion enthält. Bei einer 2%igen PAni-/DMSO-Dispersion müßte der DBSH-Gehalt in Isopropanol also ca. 1,5 % betragen. Verwendet man zuviel Säure, z.B. DBSH, flockt die Dispersion aus.

Mit einer derartig hergestellten Dispersion können dann Beschichtungen hergestellt werden. Die Schichtdicke kann durch mehrmaliges Beschichten oder durch Verdünnen der Dispersion mit Isopropanol variiert werden. Zur Herstellung gut transparenter Beschichtungen hat sich eine Verdünnung von 1:1 bewährt.

### Beispiel 8

### Beschichtungsverfahren (z.B. PC)

Man nehme eine mit Methanol gereinigte Polycarbonatfolie und tauche diese kurz in eine Dispersion aus Beispiel 7. Beim Herausziehen achte man auf gleichmäßiges Ablaufen der Dispersion.

Beste Haftfestigkeit erreicht man bei Trocknung mit IR-Bestrahlung, jedoch ist auch eine Trocknung im Heißluftofen ab 80-140 °C möglich.

Eine derart beschichtete Folie ist grünlich transparent und der Oberflächenwiderstand beträgt ca. 10⁶ Ω. Er kann durch Nachkomplexieren mit z.B. para-Toluolsulfonsäure oder HCl deutlich erniedrigt werden, z.B. auf 10³ Ω. Die spezifische Leitfähigkeit beträgt ca. 1 S/cm.

## Patentansprüche

1. Verfahren zum Beschichten eines Substrates mit unlöslichem intrinsisch leitfähigem Polyanilin unter Ausbildung dünner Schichten mit einer spezifischen Leitfähigkeit von > 1·10⁻² S/cm, **dadurch gekennzeichnet**, daß durch Kontaktieren mit einer metastabilen Dispersion, welche 0,1 bis 5 .% Polyanilin in reversibel dotierter Form mit einem Gegenanion mit einem Molekulargewicht von ≤ 1000 in einem Dispergiermittel enthält, auf dem beheizten oder unbeheizten Substrat stromlos mindestens eine Schicht des Polyanilins abgeschieden, das beschichtete Substrat erwärmt und das Dispergiermittel entfernt wird.

2. Verfahren nach Anspruch 1, **dadurch gekennzeichnet**, daß Schichten mit einer Schichtdicke < 10 µm erzeugt werden.

3. Verfahren nach einem der Ansprüche 1 oder 2, **dadurch gekennzeichnet**, daß die Abscheidung des Polyanilins aus der Dispersion zur Erzeugung elektrisch hochleitfähiger Schichten höherer Dicke mehrfach wiederholt wird.

4. Verfahren nach einem der Ansprüche 1 bis 3, **dadurch gekennzeichnet**, daß das Substrat auf oberhalb 60°C erhitzt und anschließend abgekühlt wird.

5. Verfahren nach einem der Ansprüche 1 bis 4, **dadurch gekennzeichnet**, daß die Wärmebehandlung während der Trocknung vorgenommen wird.

6. Verfahren nach einem der Ansprüche 1 bis 5, **dadurch gekennzeichnet**, daß die Wärmebehandlung unter Inertatmosphäre oder unter reduziertem Druck (Vakuum) vorgenommen wird.

7. Verfahren nach einem der Ansprüche 1 bis 6, **dadurch gekennzeichnet**, daß die Erwärmung des Substrats und der aufgebrachten Schicht durch direkten Kontakt mit einer Wärmequelle oder durch Infrarotstrahlung oder durch Mikrowellen erfolgt.

8. Verfahren nach einem der Ansprüche 1 bis 7, **dadurch gekennzeichnet**, daß das zumindest beim ersten Abscheidungsschritt verwendete Substrat von der aus dem Polyanilin aufgebauten Schicht getrennt wird.

9. Verfahren nach einem der Ansprüche 1 bis 8, **dadurch gekennzeichnet**, daß Polyanilin-Dispersionen in wässrigen Medien oder in niedermolekularen organischen Lösungsmitteln verwendet werden.

10. Verfahren nach einem der Ansprüche 1 bis 9, **dadurch gekennzeichnet**, daß als Substrate zur Beschichtung Kunststoffe, Keramiken, Naturstoffe, Gläser, Pigmente, Füllstoffe, Ruße, Fasern, Gewebe, Halbleiter oder Metalle verwendet werden, die erforderlichenfalls vor der Beschichtung gereinigt worden sind.

11. Verfahren nach einem der Ansprüche 1 bis 10, **dadurch gekennzeichnet**, daß die Beaufschlagung bei Temperaturen oberhalb 25°C vorgenommen wird.

12. Verfahren nach Anspruch 11, **dadurch gekennzeichnet**, daß die Wärmebehandlung während der Abscheidung der Schicht vorgenommen wird.

13. Zur Durchführung des Verfahrens der Ansprüche 1 bis 12 geeignete Dispersion von 0,1 bis 5 .% Polyanilin, das durch Oxydationsmittel oder Säuren in eine elektrisch leitfähige Form mit einem Gegenanion mit einem Molekulargewicht von ≤ 1000 überführt ist, in wäßrigen oder organischen Medien mit einem Löslichkeitsparameter von ≥ 8,6 [cal/cm³]^{1/2}, die sich beim Filtrieren durch ein Druckfilter mit einer Porenweite von 250 nm nicht entfärbt.

14. Dispersion nach Anspruch 13, welche dadurch herstellbar ist, daß man ein fertig polymerisiertes, gereinigtes und ggf. getrocknetes, Polyanilin in neutraler (nicht komplexierter) Form in eine Vordispersion überführt, indem man es in DMSO, DMF, THF oder einem anderen Lösungsmittel mit etwa gleichem oder höherem Löslichkeitsparameter dispergiert und anschließend mit demselben Lösungsmittel(gemisch) oder mit einem weiteren Lösungsmittel(gemisch) mit einem Löslichkeitsparameter von > 8,6 [cal/cm³]^{1/2} verdünnt, und schließlich das neutrale Polyanilin mit einer Säure in die leitfähige komplexierte Form überführt.

15. Anwendung des Verfahrens der Ansprüche 1 bis 12 in der Elektrotechnik, im Korrosionsschutz, zur (transparenten) antistatischen Ausrüstung, insbesondere zur Verpackung von elektronischen Bauelementen oder zur Herstellung nicht-schwarzer, gefärbter antistatischer Synthesefasern, in der Halbleitertechnik, insbesondere zur Herstellung von Solarzellen, Dioden, Transistoren, Feldeffekttransistoren, piezoelektrischen Impulsgebern, als elektrochrome Displays, zur potentialgesteuerten Absorption von Sonnenlicht, zur elektromagnetischen Abschirmung, insbesondere bei Lichtleitern oder bei transparenten Bauteilen wie Bildschirmen, und als dünne oder ultradünne Leiterbahnen und schichten.

## Claims

1. Process for coating a substrate with insoluble intrinsically conductive polyaniline to form thin layers having a specific conductivity of > 1·10⁻² S/cm, characterized in that, by contact with a metastable dispersion containing from 0.1 to 5% of polyaniline in reversibly doped form having a counter-anion which has a molecular weight of ≤ 1000 in a dispersion medium, at least one layer of the polyaniline is deposited, without electric current, on the heated or unheated substrate, the coated substrate is warmed, and the dispersion medium is removed.

2. Process according to Claim 1, characterized in that layers having a layer thickness of < 10 µm are produced.

3. Process according to any one of Claims 1 and 2, characterized in that the deposition of the polyaniline from the dispersion is repeated a number of times in order to produce relatively thick layers of high electrical conductivity.

4. Process according to any one of Claims 1 to 3, characterized in that the substrate is heated to above 60°C and subsequently cooled.

5. Process according to any one of Claims 1 to 4, characterized in that the heat treatment is carried out during the drying.

6. Process according to any one of Claims 1 to 5, characterized in that the heat treatment is carried out under an inert atmosphere or under reduced pressure (vacuum).

7. Process according to any one of Claims 1 to 6, characterized in that the substrate and the layer deposited thereon are warmed by direct contact with a heat source or by infrared radiation or by microwaves.

8. Process according to any one of Claims 1 to 7, characterized in that the substrate used at least in the first deposition step is separated from the layer formed from the polyaniline.

9. Process according to any one of Claims 1 to 8, characterized in that polyaniline dispersions in aqueous media or in low-molecular-weight organic solvents are used.

10. Process according to any one of Claims 1 to 9, characterized in that the substrates to be coated are plastics, ceramics, natural materials, glasses, pigments, fillers, carbon blacks, fibres, fabrics, semi-conductors or metals, and the substrates are, if necessary, cleaned before coating.

11. Process according to any one of Claims 1 to 10, characterized in that the treatment carried out at temperatures above 25°C.

12. Process according to Claim 11, characterized in that the heat treatment is carried out during the deposition of the layer.

13. Dispersion suitable for carrying out the process according to Claims 1 to 12, containing from 0.1 to 5% of polyaniline which has been converted by oxidants or by acids into an electrically conductive form having a counter-anion which has a molecular weight of ≤ 1000, in aqueous or organic media having a solubility parameter of ≥ 8.6 [cal/cm³]^{½}, which dispersion does not lose its colour when filtered through a pressure filter having a pore width of 250 nm.

14. Dispersion according to Claim 13, which can be prepared by converting an already polymerized, purified and, if appropriate, dried polyaniline in neutral (not complexed) form into a predispersion by dispersing it in DMSO, DMF, THF or another solvent having about the same or a higher solubility parameter, and then diluting it with the same solvent (mixture) or with a different solvent (mixture) having a solubility parameter of > 8.6 [cal/cm³]^{½}, and finally converting the neutral polyaniline into the conductive complexed form using an acid.

15. Use of the process according to Claims 1 to 12 in electrical engineering, in corrosion protection, for (transparent) antistatic finishing, in particular for packaging electronic components or for producing non-black, coloured antistatic synthetic fibres, in semi-conductor engineering, in particular for producing solar cells, diodes, transistors, field-effect transistors, piezoelectric pulse generators, as electrochromic displays, for the voltage-controlled absorption of sunlight, for electromagnetic screening, in particular of optical fibres or of transparent components such as display screens, and as thin or ultra-thin conductor tracks and layers.

## Revendications

1. Procédé de revêtement d'un substrat avec de la polyaniline insoluble intrinsèquement conductrice par formation de couches minces avec une conductivité spécifique de > 1 • 10⁻² S/cm, caractérisé en ce que l'on dépose par contact avec une dispersion métastable, qui contient entre 0,1 et 5% de polyaniline sous forme dopée de manière réversible avec un contre-anion ayant un poids moléculaire de ≤ 1000 dans un agent dispersant, au moins une couche de polyaniline, sans courant sur le substrat chauffé ou non chauffé, qu'on chauffe le substrat revêtu et qu'on élimine l'agent dispersant.

2. Procédé selon la revendication 1, caractérisé en ce que les couches sont réalisées avec une épaisseur de couche < 10 µm.

3. Procédé selon l'une des revendications 1 ou 2, caractérisé en ce que le dépôt de la polyaniline à partir de la dispersion est répété plusieurs fois pour réaliser des couches de haute conductivité électrique de plus grande épaisseur.

4. Procédé selon l'une des revendications 1 à 3, caractérisé en ce que l'on chauffe le substrat au dessus de 60°C et qu'on le refroidit ensuite.

5. Procédé selon l'une des revendications 1 à 4, caractérisé en ce que l'on effectue le traitement thermique pendant le séchage.

6. Procédé selon l'une des revendications 1 à 5, caractérisé en ce que l'on effectue le traitement thermique sous atmosphère inerte ou sous pression réduite (vide).

7. Procédé selon l'une des revendications 1 à 6, caractérisé en ce que l'on réalise le chauffage du substrat et de la couche déposée par contact direct avec une source de chaleur ou par rayonnement infrarouge ou par micro-ondes.

8. Procédé selon l'une des revendications 1 à 7, caractérisé en ce que l'on sépare le substrat utilisé au moins à la première étape de dépôt de la couche déposée à partir de la polyaniline.

9. Procédé selon l'une des revendications 1 à 8, caractérisé en ce que les dispersions de polyaniline sont utilisées dans des milieux aqueux ou dans des solvants organiques de faible poids moléculaire.

10. Procédé selon l'une des revendications 1 à 9, caractérisé en ce que l'on utilise comme substrats pour le dépôt des matières synthétiques, des céramiques, des matière naturelles, des verres, des pigments, des matériaux de remplissage, des suies, des fibres, du tissu, des semi-conducteurs ou des métaux, qui ont été nettoyés si nécessaire avant le dépôt.

11. Procédé selon l'une des revendications 1 à 10, caractérisé en ce que le trempé est effectué à des températures au dessus de 25°C.

12. Procédé selon la revendication 11, caractérisé en ce que le traitement thermique est effectué pendant le dépôt de la couche.

13. Dispersion appropriée de 0,1 jusqu'à 5% de polyaniline pour la réalisation du procédé des revendications 1 à 12, qui est transformée au moyen d'agents d'oxydation ou d'acides en une forme électriquement conductrice avec un contre-anion ayant un poids moléculaire de ≤ 1000, dans des milieux aqueux ou organiques avec un paramètre de solubilité de ≥ 8,6 [cal/cm³]^{1/2}, qui ne se décolore pas au cours de la filtration à travers un filtre sous pression avec une largeur de pores de 250 nm.

14. Dispersion selon la revendication 13, qu'on peut préparer en réalisant une polyaniline complètement polymérisée, purifiée et éventuellement séchée sous forme neutre (non complexée) dans une prédispersion, en la dispersant dans le DMSO, le DMF, le THF ou un autre solvant avec environ le même ou un paramètre de solubilité plus élevé et en la diluant ensuite avec le même solvant (mélange de solvants) ou avec un autre solvant (mélange de solvants) avec un paramètre de solubilité de > 8,6 [cal/cm³]^{1/2}, et en transformant ensuite la polyaniline neutre avec un acide en la forme complexée conductrice.

15. Utilisation du procédé des revendications 1 à 12 en électrotechnique, en protection contre la corrosion, au blindage antistatique (transparent), en particulier au conditionnement de composants électroniques ou pour la fabrication de fibres de synthèse antistatiques colorées, non noires, dans la technologie des semi-conducteurs, en particulier pour la fabrication de cellules solaires, de diodes, de transistors, de transistors à effet de champ, de générateurs d'impulsions piézo-électriques, comme afficheurs électrochromes, pour l'absorption régulée en potentiel de la lumière solaire, pour le blindage électromagnétique, en particulier pour les conducteurs optiques ou pour les composants transparents comme les écrans, ou comme pistes et couches conductrices minces et ultraminces.
